# EUROPÄISCHE PATENTSCHRIFT

(11) **EP 3 715 882 B1**
(45) Veröffentlichungstag und Bekanntmachung des Hinweises auf die Patenterteilung: **07.06.2023**
(21) Anmeldenummer: 20156539.7
(22) Anmeldetag: 11.02.2020
(51) Int. Cl.: G01R 31/12, H02H 1/00

(54) **MESSEMPFÄNGER UND MESSVORRICHTUNG ZUR ERFASSUNG VON TEILENTLADUNGEN**
MEASURING RECEIVER AND MEASURING DEVICE FOR DETECTING PARTIAL DISCHARGES
RÉCEPTEUR DE MESURE ET DISPOSITIF DE MESURE POUR LA DÉTECTION DES DÉCHARGES PARTIELLES

(30) Priorität: 20.03.2019 DE 102019107074
(43) Veröffentlichungstag der Anmeldung: 30.09.2020
(73) Patentinhaber: Megger Germany GmbH, 96148 Baunach (DE)
(72) Erfinder: Götz, Daniel, 96148 Baunach (DE)
(74) Vertreter: Marschall, Stefan

(56) Entgegenhaltungen:
- CN-A- 108 120 905
- CN-U- 203 630 292
- Anonymous: "The Description Description Advantages of Ultra Sound Testing Advantages of Ultra Sound Testing", , 2. März 2015 (2015-03-02), XP055723293, Gefunden im Internet: URL:https://pdf.indiamart.com/impdf/939738 2691/MY-4307892/partial-discharge-detector .pdf [gefunden am 2020-08-18]

## Beschreibung

Die Erfindung betrifft zunächst einen Messempfänger zur Erfassung von Teilentladungen spannungsführender Bauteile in Hochspannungsanlagen, wobei der Messempfänger einen Parabolspiegel aufweist, der zum Fokussieren von durch elektrische Teilentladungen unter anderem hervorgerufener Ultraschallstrahlung auf einen an einem verjüngten Ausleger einer Halteeinheit angeordneten Ultraschallwandler dient und die Halteeinheit einen Handgriff für einen Benutzer aufweist. Darüber hinaus hat die Erfindung eine Messvorrichtung zur Erfassung von Teilentladungen spannungsführender Bauteile in Hochspannungsanlagen, insbesondere unter Verwendung eines derartigen Messempfängers, zum Gegenstand.

Elektrische Teilentladungen in Hochspannungsanlagen können zu einem vorzeitigen Ausfall hiervon betroffener Bauteile oder Anlagenteile führen. Daher besteht ein stark erhöhtes Interesse daran, etwaige Teilentladungen frühzeitig aufzuspüren, um Abhilfe zu schaffen. Zu diesem Zweck existieren Messvorrichtungen, die von elektrischen Teilentladungen ausgehende akustische Geräusche im Ultraschallbereich und/oder von den Teilentladungen ausgehende hochfrequente elektromagnetische Impulse erfassen und räumlich hinreichend präzise lokalisieren können.

Zur akustischen Erfassung der Teilentladung sind Messvorrichtungen in der Form eines Ultraschallempfängers mit einem Parabolspiegel zur Erhöhung der akustischen Empfindlichkeit bekannt, die sich als ein Zubehörteil an eine entsprechend ausgebildete elektronische Auswerteeinheit mit einer bevorzugt integrierten optischen und/oder akustischen Ausgabeeinheit anschließen lassen und im Zusammenwirken eine zur Erfassung der Teilentladungen geeignete Messvorrichtung darstellen. Darüber hinaus sind Ultraschall-Richtmikrofone mit einer integrierten elektronischen Auswerte- und Ausgabeeinheit bekannt, die für sich eine vollständige, zur Detektion von Teilentladungen geeignete Messvorrichtung verkörpern. Zum Einsatz in besonders lauten Umgebungen können an die vorbekannten Messvorrichtungen in der Regel zusätzlich Kopfhörer angeschlossen werden. Die Parabolspiegel sind mit einer Halteeinheit zur Gewährleistung einer ergonomisch vorteilhaften Handhabung der Messvorrichtung durch den Benutzer verbunden. Aus der CN 108 120 905 A sind ein Verfahren und eine Vorrichtung zum Erfassen von Teilentladungen eines Elektrogeräts bekannt. Die Druckschrift CN 203 630 292 U offenbart einen Ultraschalldetektor.

Ein Nachteil der vorbekannten Messempfänger und Messvorrichtungen zur Detektion von Teilentladungen an Hochspannungsbauteilen ist darin zu sehen, dass diese relativ viel Lagerraum bei Nichtgebrauch beanspruchen.

Aufgabe der Erfindung ist es, einen Messempfänger bzw. eine Messvorrichtung zu schaffen, die bei Nichtgebrauch einen möglichst geringen Lagerraum beanspruchen.

Die eingangs genannte Aufgabe wird zunächst gelöst durch einen Messempfänger mit den kennzeichnenden Merkmalen des Patentanspruchs 1, wonach die Halteeinheit zeitweise und zentrisch mit dem Parabolspiegel mechanisch koppelbar ist. Hierdurch lässt sich der Messempfänger, insbesondere zu Transport-zwecken, besonders platzsparend zerlegen. Der mit der Halteeinheit und mit dem Parabolspiegel aufgebaute Messempfänger wird zur Schaffung einer einsatzfähigen Messvorrichtung zur Detektion von Teilentladungen an eine geeignete elektronische Auswerteeinheit mit einer integrierten optischen und/oder akustischen Ausgabeeinheit angeschlossen. Gegebenenfalls kann die elektronische Auswerteeinheit mit der Ausgabeeinheit auch in die Halteeinheit des Messempfängers mit integriert sein.

Erfindungsgemäß ist ein rückseitiger Adapter des Parabolspiegels mit einem Anschlusselement der Halteeinheit durch eine Bajonettverbindung und/oder eine Magnetverbindung koppelbar. Infolgedessen ist eine für den Benutzer intuitive und leichte Koppelbarkeit des Parabolspiegels an die Halteeinheit gegeben.

Bei einer technisch vorteilhaften Ausgestaltung ist die Magnetverbindung mit mindestens einem Magneten des rückseitigen Adapters und/oder mit mindestens einem Magneten des Anschlusselements der Halteeinheit gebildet. Hierdurch ist eine besonders einfache Koppelbarkeit der Halteeinheit mit dem Parabolspiegel gegeben, wobei zugleich eine mechanisch hinreichend belastbare Verbindung gewährleistet ist.

Bevorzugt ist der mindestens eine Magnet der Magnetverbindung im Wesentlichen hohlzylindrisch ausgebildet. Infolgedessen ist eine besonders robuste magnetische Verbindung zwischen dem Parabolspiegel und der Halteeinheit gewährleistet, die zudem unabhängig von der relativen Drehposition zwischen Parabolspiegel und der Halteeinheit herstellbar ist.

Im Fall einer weiteren Ausgestaltung ist die Magnetverbindung mit mehreren von im Wesentlichen umfangsseitig gleichmäßig zueinander beabstandet angeordneten sowie angenähert zylindrischen Magneten des Anschlusselements der Halteeinheit und mit einer gleichen Anzahl von im Wesentlichen umfangsseitig gleichmäßig zueinander beabstandet angeordneten und angenähert zylindrischen Magneten des Adapters des Parabolspiegels gebildet, wobei die Magnete des Adapters und des Anschlusselements magnetisch entgegengesetzt gepolt sind und im mechanisch gekoppelten Zustand von Halteeinheit und Parabolspiegel im Wesentlichen deckungsgleich aneinander liegen. Hierdurch lässt sich der Adapter des Parabolspiegels durch geringfügiges umfangsseitiges Verdrehen in Relation zum Anschlusselement der Halteeinheit oder umgekehrt entgegen der von der Vielzahl der Magnete erzeugten hohen magnetischen Haftkraft leicht von dem Anschlusselement trennen. Die Magnete sind bevorzugt als Permanentmagnete ausgeführt, die mit Werkstoffen aus der Gruppe der seltenen Erden gefertigt sind. Die Magnete weisen eine im Wesentlichen zylindrische Geometrie auf und sind jeweils im Wesentlichen axial bündig abschließend in den Adapter am Parabolspiegel sowie in das Anschlusselement an der Halteeinheit eingelassen.

Vorzugsweise weist das Anschlusselement der Halteeinheit mindestens ein Führungselement, insbesondere mindestens ein Zentrierelement, für den Parabolspiegel auf. Infolgedessen ist ein zuverlässiger Sitz des Parabolspiegels auf der Halteeinheit gewährleistet.

Bei einer günstigen Weiterbildung weist die Halteeinheit eine Laserzieleinheit zur Erzeugung einer Laserstrahlung zum Anvisieren eines Messobjekts mittels des Messempfängers auf. Infolgedessen ist eine präzise Anpeilung von auf das Vorhandensein von elektrischen Teilentladungen zu untersuchenden Messobjekten bzw. spannungsführenden Bauteilen von Hochspannungsanlagen mittels der Halteeinheit möglich.

Bei einer technisch günstigen Weiterbildung weist der Parabolspiegel zumindest bereichsweise eine Filterzone auf, die für die Laserstrahlung der Laserzieleinheit selektiv durchlässig ist. Hierdurch bleibt die von der Laserzieleinheit in Richtung eines angepeilten bzw. anvisierten Messobjekts oder eines zu untersuchenden Hochspannungsbauteils abgegebene Laserstrahlung, die vom Messobjekt unter Schaffung eines den Messpunkt repräsentierenden Laserpunkts als Reflexionsstrahlung teilweise wieder zurückgeworfen wird, im Wesentlichen unbeeinträchtigt. Demgegenüber wird beispielsweise die Erkennbarkeit des Laserpunkts beeinträchtigende Sonnenstrahlung oder das Tageslicht stark bedämpft. Hieraus resultiert eine erheblich verbesserte Sichtbarkeit des von der Laserzieleinheit am Messobjekt erzeugten Laserpunkts für den Benutzer. Durch die Integration eines optischen Filters in der Form einer flächenbehafteten Filterzone in den Parabolspiegel sind Filterbrillen oder dergleichen entbehrlich. Die Laserzieleinheit kann zum Beispiel elektromagnetische Strahlung mit etwa 632 nm, das heißt monochromatisches, gebündeltes rotes Laserlicht abgeben. Die Leistung der Laserstrahlung beträgt weniger als 1 mW, so dass ein gefahrloser Einsatz der Laserzieleinheit im öffentlichen Raum gewährleistet ist.

Nach Maßgabe einer weiteren vorteilhaften Ausgestaltung ist der Parabolspiegel zumindest bereichsweise für sichtbares Licht durchlässig ausgebildet. Infolgedessen ist eine alternative Zieleinheit, wie zum Beispiel Kimme und Korn, zur Ausrichtung der Messvorrichtung auf ein Messobjekt bzw. ein elektrisches Bauteil einer Hochspannungsanlage verwendbar. Unter dem Terminus des sichtbaren Lichts wird ein Gemisch nichtkohärenter elektromagnetischer Strahlung in einem Wellenlängenbereich zwischen etwa 380 nm und ungefähr 780 nm verstanden.

Bei einer weiteren Ausgestaltung ist dem Ultraschallwandler mindestens ein elektronischer Verstärker zugeordnet. Infolgedessen kann die Gefahr einer Verfälschung des vom Ultraschallwandler abgegebenen Messsignals auf dem Weg bis zur elektronischen Auswerteeinheit verringert werden.

Darüber hinaus wird die eingangs genannte Aufgabe durch die kennzeichnenden Merkmale des Patentanspruchs 10 gelöst, wonach zur Schaffung der Messvorrichtung eine elektronische Auswerte- und Ausgabeeinheit mit in die Halteeinheit des Messempfängers integriert ist oder die elektronische Auswerte- und Ausgabeeinheit extern angeordnet und mittels geeigneter elektrischer und/oder optischer Leitungen mit dem mindestens einen Verstärker des Ultraschallwandlers oder direkt mit dem Ultraschallwandler verbunden ist. Hierdurch ist ein besonders kompakter und für den Benutzer ergonomisch vorteilhaft zu handhabender Messaufbau realisierbar. Bei der Integration der elektronischen Auswerteeinheit in die Halteeinheit der Messvorrichtung ist dieser zudem bevorzugt eine optische und/oder akustische Ausgabeeinheit zur Ausgabe der Teilentladungsmessergebnisse an den Benutzer beigeordnet. Bei der Ausgabeeinheit kann es sich zum Beispiel um einen Lautsprecher und/oder ein LCD-Display oder dergleichen handeln. Weiterhin kann für den Einsatz der Messvorrichtung in Umgebungen mit stark erhöhtem Lautstärkepegel vorzugsweise eine Anschlussoption für einen Kopfhörer vorgesehen sein. Für den Fall, dass die digitale Auswertung des von dem elektronischen Verstärker aufbereiteten Ausgangssignals des Ultraschallwandlers eine zu hohe Rechenleistung erfordert, kann die dann mehr Bauraum beanspruchende elektronische Auswerteeinheit auch außerhalb der Halteeinheit angeordnet und mit dieser über optische und/oder elektrische Leitungen verbunden sein. Die Speisung des Ultraschallwandlers sowie des elektronischen Verstärkers mit elektrischer Energie erfolgt in jedem Fall mittels der elektronischen Auswerteeinheit, die zu diesem Zweck bevorzugt über eine geeignete netzunabhängige Stromversorgung verfügt.

Im Folgenden wird ein bevorzugtes Ausführungsbeispiel der Erfindung anhand von schematischen Figuren näher erläutert. Es zeigen
- Figur 1: eine prinzipielle Seitenansicht einer Halteeinheit eines erfindungsgemäßen Messempfängers,
- Figur 2: einen detaillierten Längsschnitt des Parabolspiegels,
- Figur 3: eine Draufsicht auf den Parabolspiegel von Figur 2,
- Figur 4: eine schematische Seitenansicht des mit der Halteeinheit von Figur 1 zur Schaffung des Messempfängers gekoppelten Parabolspiegels nach Maßgabe der Figuren 2, 3, und
- Figur 5: eine perspektivische Teilansicht des von der Halteeinheit getrennten Parabolspiegels des Messempfängers von Figur 4 mit einer Ausführungsform einer Magnetverbindung.

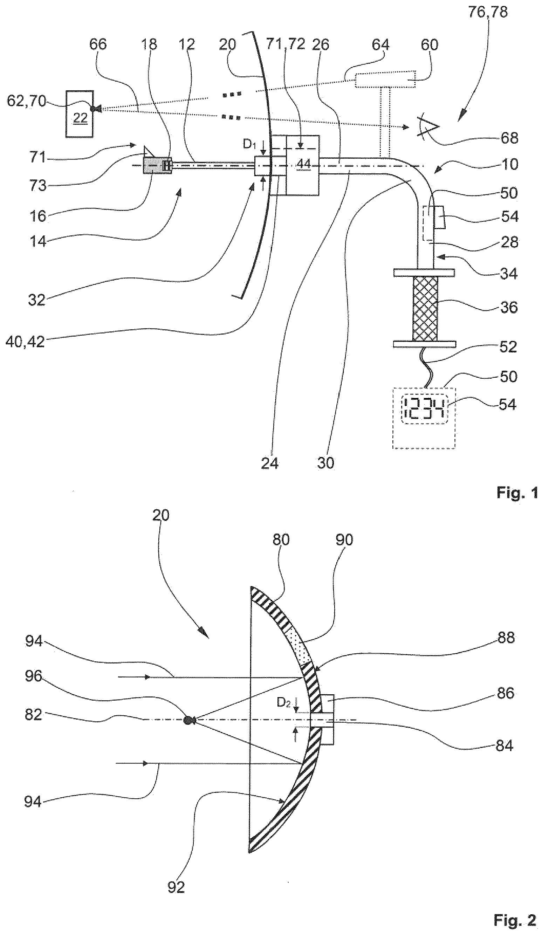

Die Figur 1 illustriert eine prinzipielle Seitenansicht einer Halteeinheit eines erfindungsgemäßen Messempfängers. Eine Halteeinheit 10 umfasst einen verjüngten Ausleger 12, an dessen freien Ende 14 ein Ultraschallwandler 16 angeordnet ist. Von dem Ultraschallwandler 16 erzeugte elektrische Messsignale werden hier lediglich beispielhaft mittels eines in den Ultraschallwandler 16 integrierten elektronischen Verstärkers 18 entsprechend verstärkt. Der Ultraschallwandler 16 ist in einem Brennpunkt eines hier zeichnerisch lediglich angedeuteten Parabolspiegels 20 (vgl. insb. Figur 2; Bezugsziffer 96) positioniert. Durch den Parabolspiegel 20 ergibt sich eine ausgezeichnete Richtcharakteristik des Ultraschallwandlers 16 nach Art eines aus der Tontechnik bekannten Richtmikrofons. Infolgedessen wird von Teilentladungen in einem Messobjekt 22 ausgehende, in den Figuren nicht dargestellte Ultraschallstrahlung auf den Ultraschallwandler 16 fokussiert und konzentriert und infolgedessen verstärkt. Der Ultraschallwandler 16 ist zur Messung von Ultraschall in einem Frequenzbereich von etwa 18 kHz bis hin zu mehreren 1.000 kHz ausgebildet, der üblicherweise von elektrischen Teilladungen in oder an spannungsführenden Bauteilen in Energieversorgungsanlagen, Hochspannungsanlagen etc. ausgeht.

Die Halteeinheit 10 verfügt über einen pistolenartig gebogenen Grundkörper 24, der mit einem ersten und einem zweiten Schenkel 26, 28 gebildet ist, die hier durch einen Winkelabschnitt 30 unter einem Winkel von etwa 90° miteinander verbunden sind. Die beiden Schenkel 26, 28 unter Einschluss des sie verbindenden Winkelabschnitts 30 können jeweils rohrartig ausgebildet sein. Der Ausleger 12 für den Ultraschallwandler 16 ist an einem Endabschnitt 32 des ersten Schenkels 26 ausgebildet, während an einem Endabschnitt 34 des zweiten Schenkels 28 der Halteeinheit 10 ein ergonomisch ausgeformter Handgriff 36 zur manuellen Handhabung der Halteeinheit 10 durch einen in den Zeichnungen nicht dargestellten Benutzer vorgesehen ist. Im Bereich des Endabschnitts 32 des ersten Schenkels 26 sind ferner ein als Zentrierelement 40 ausgebildetes Führungselement 42 sowie ein Anschlusselement 44 zur mechanischen Ankopplung des Parabolspiegels 20 vorgesehen. Das hier lediglich beispielhaft zylindrische Zentrierelement 40 für den Parabolspiegel 20 weist einen Außendurchmesser D₁ auf. Die zeichnerisch nicht dargestellten, vom elektronischen Verstärker 18 ausgehenden elektrischen Messsignale werden einer elektronischen Auswerteeinheit 50 zugeführt, die in die Halteeinheit 10 integriert sein kann oder die extern, das heißt räumlich beabstandet zu der Halteeinheit 10 angeordnet sein kann. Innerhalb der elektronischen, vorzugsweise digitalen Auswerteeinheit 50 erfolgt die Aufbereitung der Messsignale und deren komplexe numerische Analyse. Im Fall einer externen Anordnung der Auswerteeinheit 50 ist diese mit Hilfe geeigneter elektrischer und/oder optischer Leitungen 52 zur Signalübertragung mit dem elektronischen Verstärker 18 verbunden oder im Fall eines nicht vorhandenen (Vor-)Verstärkers 18 unmittelbar signaltechnisch an den Ultraschallwandler 16 angebunden. Bevorzugt ist der elektronischen Auswerteeinheit 50 eine optische und/oder akustische Ausgabeeinheit 54 zugeordnet, um die die elektrischen Teilentladungen repräsentierenden Messwerte des Ultraschallwandlers 16 und in der elektronischen Auswerteeinheit 50 aufbereiteten Messwerte in einer für den Benutzer intuitiv wahrnehmbaren Form auszugeben. In lautstarken Umgebungen kann zudem eine akustische Ausgabe mithilfe eines nicht dargestellten Kopfhörers erfolgen, der an die elektronische Auswerteeinheit 50 anschließbar ist. Darüber hinaus ist in die elektronische Auswerteeinheit 50 bevorzugt eine nicht dargestellte netzunabhängige Stromversorgung integriert, mittels der die elektronische Auswerteeinheit 50, die optische und/oder akustische Ausgabeeinheit, der optionale elektronische Verstärker 18, der Ultraschallwandler 16 sowie die Laserzieleinheit 60 über einen hinreichenden Zeitraum hinweg mit der betriebsnotwendigen elektrischen Energie versorgt werden können.

Weiterhin kann die Halteeinheit 10 mit einer Laserzieleinheit 60 ausgerüstet sein, um eine präzise Ausrichtung des Parabolspiegels 20 auf einen auf etwaige elektrische Teilentladungen hin zu untersuchenden Messpunkt 62 an einem Messobjekt 22 zu erleichtern bzw. überhaupt zu ermöglichen. Zu diesem Zweck sendet die Laserzieleinheit 60 eine möglichst scharf gebündelte Laserstrahlung 64 aus, die im Messpunkt 62 als Reflexionsstrahlung 66 teilweise zurückgeworfen wird und einen für das Auge 68 des Benutzers gut sichtbaren Laserpunkt 70 hervorruft. Die Laserzieleinheit 60 arbeitet in einem für das menschliche Auge 68 sichtbaren Bereich, wie zum Beispiel mit monochromer roter Laserstrahlung bzw. Laserlicht mit einer Frequenz von etwa 632 nm. Anstelle roter Laserstrahlung kann auch gelbe, orange, grüne oder blaue Laserstrahlung Verwendung finden, für die das Auge 68 des Benutzers eine deutlich höhere Empfindlichkeit aufweist.

Der Parabolspiegel 20 weist zumindest bereichsweise eine hier nicht dargestellte Filterzone auf, die die Laserstrahlung 64 sowie die Reflexionsstrahlung 66 weitgehend ungehindert passieren lässt (vgl. insb. Figur 2, Bezugsziffer 90), jedoch für unerwünschte Störstrahlung in der Form von Sonnenlicht, Tageslicht, künstlicher Beleuchtung etc. weitgehend undurchlässig ist. Infolgedessen wird die optische Wahrnehmbarkeit des Laserpunktes 70 auf dem Messobjekt 22 für den Benutzer beträchtlich verbessert.

Kommt beispielsweise rote Laserstrahlung 64 zum Einsatz, so ist die Filterzone mit einem roten Glas- oder Kunststoffmaterial gebildet, während die verbleibenden Flächenanteile des Parabolspiegels 20 mit einem lichtundurchlässigen Material gebildet sein können. Hierdurch wird im Bereich der Filterzone störende Sonnenstrahlung, Tageslicht oder Kunstlicht praktisch vollständig unterdrückt, wohingegen die rote Laserstrahlung 64 der Laserzieleinheit 60 die Filterzone weitestgehend ungehindert passieren kann.

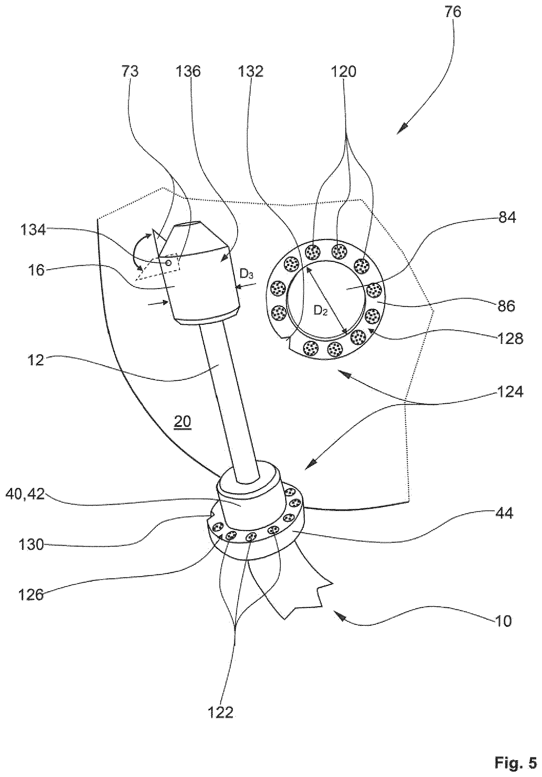

Alternativ kann der Parabolspiegel 20 zumindest bereichsweise mit einem für sichtbares, weißes Licht vollständig durchlässigen Material gebildet sein, um zum Beispiel eine herkömmliche optische Peil- oder Zielvorrichtung 71 einsetzen zu können. Diese konventionelle Peil- oder Zielvorrichtung 71 kann mit einer Kimme 72 und mit einem an dem Ultraschallwandler 16 angebrachten Korn 73 realisiert sein, wobei die Kimme 72 zum Beispiel mit einer peripheren V-förmigen Kerbe bzw. einer V-Nut in dem Anschlusselement 44 und einer weiteren, hierzu deckungsgleich ausgeformten V-förmigen Kerbe bzw. einer V-Nut in dem hier nicht bezeichneten Adapter der Halteeinheit 10 gebildet sein kann (vgl. insb. Figur 5, Bezugsziffern 44, 86, 130, 132). Die beiden V-förmigen Kerben fluchten im mechanisch gekoppelten Zustand von Parabolspiegel 20 und Halteeinheit 10 - wie hier gezeigt - zur Schaffung der Kimme 72 zueinander. Um das Aufschieben des Parabolspiegels auf den Ausleger 12 mit dem Ultraschallwandler 16 zu ermöglichen, lässt sich das Korn 73 zur Sicherstellung eines bändigen Abschlusses mit dem Ultraschallwandler 16 bündig abschließend in diesen einklappen.

Der mit der Halteeinheit 10 gekoppelte Parabolspiegel 20 stellt für den Fall, dass sowohl die elektronische Auswerteeinheit 50 als auch die dieser zugeordnete optische und/oder akustische Ausgabeeinheit 54 mit in die Halteeinheit 10 integriert sind, eine vollständig autonom einsetzbare Messvorrichtung 74 zur Detektion von Teilentladungen an spannungsführenden Bauteilen von Hochspannungsanlagen dar. Sind die Auswerte- und die Ausgabeeinheit 50, 54 - wie hier mit den gestrichelten Linien angedeutet - mittels der elektrischen und/oder optischen Leitungen 52 mit der Halteeinheit 10 verbunden, so stellt die Kombination aus dem Parabolspiegel 20 und der Halteeinheit 10 lediglich einen bis auf den elektronischen Verstärker 18 lediglich passiven Messempfänger 76 dar, der für den Messbetrieb zwingend mit der elektronischen Auswerte- und Ausgabeeinheit 50, 52 verbunden werden muss.

Die Figur 2 illustriert einen detaillierten Längsschnitt des Parabolspiegels. Der Parabolspiegel 20 verfügt über einen parabolisch gekrümmten, massiven Grundkörper 80, der rotationssymmetrisch zu einer Längsmittelachse 82 ausgebildet ist. Der Grundkörper 80 kann mit einem metallischen Werkstoff und/oder mit einem geeigneten Kunststoff gebildet sein. Der Grundkörper 80 verfügt über eine Durchgangsbohrung 84, die zentrisch zur Längsmittelachse 82 ausgebildet ist und die einen Adapter 86, der zur temporären mechanischen Kopplung mit der Halteeinheit gemäß der Figur 1 zur Schaffung des vollständigen Messempfängers bestimmt ist, axial vollständig durchsetzt. Der Adapter 86 ist im Bereich einer Rückseite 88 des Parabolspiegels 20 vorgesehen und weist hier lediglich exemplarisch eine näherungsweise hohlzylindrische Geometrie auf. Ein Innendurchmesser D₂ der Durchgangsbohrung 84 ist bevorzugt so bemessen, dass beim axialen Aufschieben des Parabolspiegels 20 auf das Zentrierelement der Halteeinheit (vgl. insb. Figur 1, Bezugsziffern 10, 40) zumindest ein leichter Pressschluss herstellbar ist, um eine weitgehend spielfreie Kopplung des Parabolspiegels 20 mit der Halteeinheit 10 zu erreichen. Der Parabolspiegel 20 weist zumindest bereichsweise eine optische Filterzone 90 auf, die mit einem im Vergleich zu dem Werkstoff des Grundkörpers 80 in der Regel verschiedenen und selektiv für die von der Laserzieleinheit der Halteeinheit von Figur 1 emittierte Laserstrahlung im Wesentlichen verlustfrei durchlässigen Material gebildet ist.

Im Fall einer bevorzugten Ausführungsform erstreckt sich die Filterzone 90 über eine Gesamtfläche des Parabolspiegels 20, das heißt der ganze Parabolspiegel 20 ist vollständig mit einem für das zum Beispiel rote Laserlicht im Bereich von 632 nm der Laserzieleinheit (vgl. Fig. 1, Bezugsziffer 60) im Wesentlichen verlustfrei durchgängigen, rot durchgefärbten massiven Kunststoff gebildet. In Abhängigkeit von der Wellenlänge der Laserzieleinheit kann der Parabolspiegel auch mit einem gelben, orangen, grünen oder blauen Kunststoff gebildet sein, der für Laserlicht mit der entsprechenden Farbe im Wesentlichen verlustfrei durchlässig.

An Stelle der Filterzone 90 kann der Parabolspiegel 20 zumindest bereichsweise für sichtbares (weißes) Licht durchlässig ausgebildet sein, um eine konventionelle Zielvorrichtung wie zum Beispiel Kimme und Korn zum Anpeilen der zu untersuchenden Messobjekte verwenden zu können. Zumindest eine Vorderseite 92 des Parabolspiegels 20 verfügt über eine parabolische Oberflächengeometrie, sodass parallel zur Längsmittelachse 82 einfallende Ultraschallstrahlung 94, die von elektrischen Teilentladungen im oder an dem Messobjekt herrührt, in einem Brennpunkt 96 des Parabolspiegels 20 aufkonzentriert und somit beträchtlich verstärkt wird, wobei im Bereich des Brennpunktes 96 bevorzugt der Ultraschallwandler der Halteeinheit positioniert ist (vgl. insb. Figur 1, Bezugsziffern 10, 16).

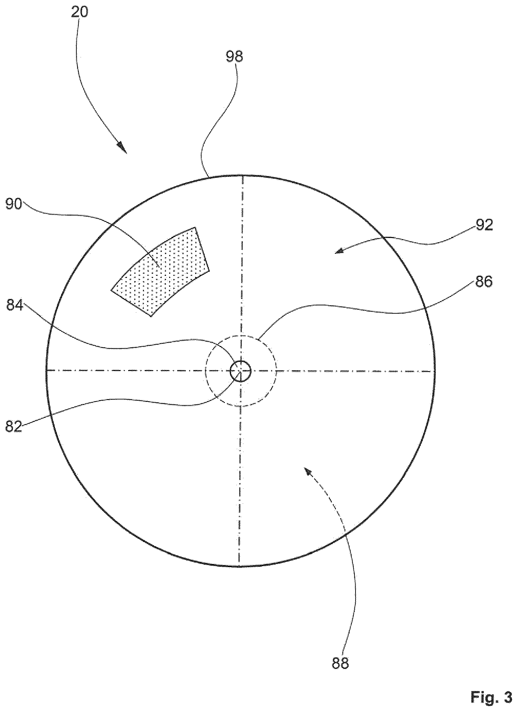

Die Figur 3 zeigt eine Draufsicht auf den Parabolspiegel von Figur 2. Zentrisch zu der Längsmittelachse 82 des Parabolspiegels 20 sind die Durchgangsbohrung 84 sowie der im Bereich der hier verdeckten Rückseite 88 des Parabolspiegels 20 angeordnete Adapter 86 angeordnet. Der Parabolspiegel 20 weist hier eine kreisrunde Umfangskontur 98 auf, kann alternativ aber auch eine von der Kreisform abweichende, zum Beispiel eine ovale oder näherungsweise elliptische Umfangskontur aufweisen. Innerhalb der Vorderseite 92 des Parabolspiegels 20 ist die Filterzone 90 erkennbar, die hier lediglich exemplarisch eine kreisringsektorförmige Geometrie aufweist.

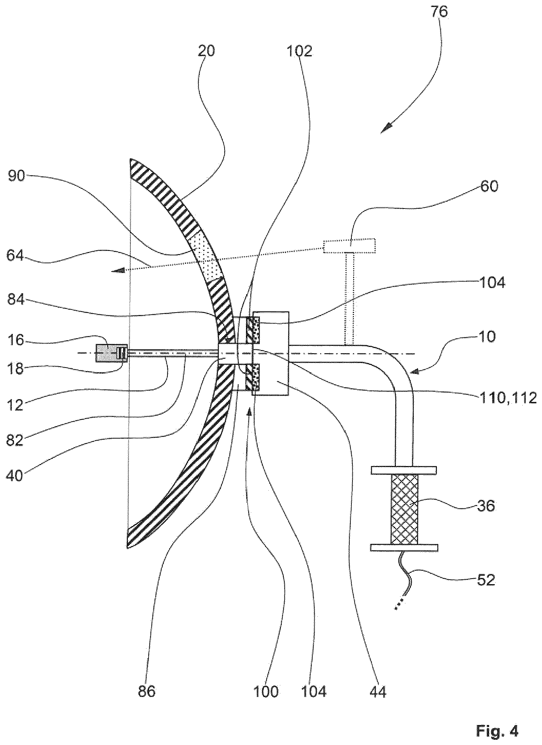

Die Figur 4 zeigt eine schematische Seitenansicht des mit der Halteeinheit von Figur 1 zur Schaffung des Messempfängers gekoppelten Parabolspiegels nach Maßgabe der Figuren 2, 3. Durch das temporäre Zusammenkoppeln der Halteeinheit 10 mit dem Parabolspiegel 20 ist der erfindungsgemäße Messempfänger 76 zur Detektion von elektrischen Teilentladungen eines Messobjekts, insbesondere an einer Komponente einer Hochspannungsanlage, gebildet. Der Parabolspiegel 20 weist die Filterzone 90 für die von der Laserzieleinheit 60 emittierte Laserstrahlung 64 auf und der am Ausleger 12 der Halteeinheit 10 fixierte Ultraschallwandler 16 mit dem nachgeschalteten elektronischen Verstärker 18 ist im Bereich des hier nicht bezeichneten Brennpunktes des Parabolspiegels 20 für die hier gleichfalls nicht dargestellte Ultraschallstrahlung positioniert.

Die Durchgangsbohrung 84 des Parabolspiegels 20 ist vollständig axial auf das zylindrische Zentrierelement 40 der Halteeinheit 10 aufgeschoben, so dass der rückseitige Adapter 86 im Idealfall vollflächig an dem Anschlusselement 44 der Halteeinheit 10 anliegt. Die mechanisch feste Kopplung zwischen dem Parabolspiegel 20 und der Halteeinheit 10 erfolgt hier lediglich exemplarisch mittels einer Magnetverbindung 100, die mit einem Magneten 102 des rückseitigen Adapters 86 und einem Magneten 104 des Anschlusselements 44 realisiert ist, wobei die beiden Magnete 102, 104 zur Erzeugung der notwendigen magnetischen Haltekraft entgegengesetzt gepolt sind. Die beiden Magnete 102, 104 sind bevorzugt ringförmig bzw. hohlzylindrisch und im Wesentlichen kongruent zueinander ausgeführt, um eine von der relativen Drehposition zwischen der Halteeinheit 10 und dem Parabolspiegel 20 um die Längsmittelachse 82 im Kopplungszeitpunkt unabhängige und zuverlässige Kopplung zu gewährleisten.

Für den Fall, dass der Adapter 86 oder das Anschlusselement 44 für sich magnetisch sind, ist es ausreichend lediglich einen der Magneten 102, 104 vorzusehen. Die beiden Magnete 102, 104 sind bevorzugt als Permanentmagneten ausgebildet, die mit einer geeigneten Werkstoffkombination aus der Gruppe der seltenen Erden gesintert sind.

Anstelle oder zusätzlich zu der Magnetverbindung 100 kann zwischen dem rückseitigen Adapter 86 des Parabolspiegels 20 und dem Anschlusselement 44 der Halteeinheit 10 eine nicht dargestellte, zumindest teilweise formschlüssige Schraub- oder Bajonettverbindung vorgesehen sein.

Bei Nichtgebrauch des Messempfängers 76 kann dieser aufgrund der lediglich temporären Magnetverbindung 100 vom Benutzer leicht in seine beiden Hauptkomponenten in Form des Parabolspiegels 20 und der Halteeinheit 10 zerlegt und platzsparend in einem Transportkoffer oder dergleichen untergebracht werden.

Mittels der optischen und/oder elektrischen Leitungen 52 erfolgt der Anschluss des Messempfängers 76 an eine hier nicht dargestellte elektronische Auswerte- und Ausgabeeinheit (vgl. insb. Figur 1, Bezugsziffern 50, 54).

Über die elektrischen Leitungen 52 erfolgt zugleich die Speisung des optionalen elektronischen Verstärkers 18 des Ultraschallwandlers 16 mit der betriebsnotwendigen elektrischen Energie. Zu diesem Zweck verlaufen nicht dargestellte elektrische und/oder optische Leitungen innerhalb der Halteeinheit 10 ausgehend von dem Handgriff 36 bis zu dem elektronischen Verstärker 18 der Halteeinheit 10.

Die Figur 5 zeigt eine perspektivische Teilansicht des von der Halteeinheit getrennten Parabolspiegels des Messempfängers von Figur 4 mit einer Ausführungsform einer Magnetverbindung.

Der im Wesentlichen hohlzylindrische Adapter 86 des Parabolspiegels 20 des Messempfängers 76 weist hier eine Anzahl von lediglich beispielhaft elf, umfangsseitig im Wesentlichen gleichmäßig zueinander beabstandet angeordneten, identischen Magneten auf, von denen hier lediglich drei Magnete 120 bezeichnet sind. Entsprechend weist das Anschlusselement 44 der Halteeinheit 10 des Parabolspiegels 20 des Messempfängers 76 gleichfalls elf, im Wesentlichen gleichmäßig zueinander beabstandete Magnete auf, von denen in der Darstellung von Figur 5 lediglich sieben Magnete sichtbar sind und von denen stellvertretend für alle übrigen drei Magnete 122 bezeichnet sind.

Die Magnete 120 des Adapters 86 und die Magnete 122 des Anschlusselements 44 bilden eine Magnetverbindung 124 aus, wenn eine Stirnfläche 126 des Anschlusselements 44 und eine Stirnfläche 128 des Adapters 86 im zusammengekoppelten Zustand von Halteeinheit 10 und Parabolspiegel 20 zumindest bereichsweise aneinander liegen, wobei sich die kongruenten und magnetisch entgegengesetzt gepolten, bevorzugt zylindrischen Magnete 120, 122 mit sehr hoher Kraftwirkung gegenseitig anziehen. Infolgedessen ist eine mechanisch äußerst robuste Verbindung zwischen dem Parabolspiegel 20 und der Halteeinheit 10 des Messempfängers 76 im gekoppelten Zustand gewährleistet. Die Magnete 120, 122 sind bevorzugt jeweils im Wesentlichen bündig abschließend mit den Stirnflächen 126, 128 ausgebildet. Die Magnete 120, 122 sind als Permanentmagnete mit einem Werkstoff aus der Gruppe der seltenen Erden hergestellt.

In dem Anschlusselement 44 ist - für den Fall dass eine herkömmliche optische Peil- oder Zielvorrichtung vorgesehen ist - eine periphere erste V-förmige Kerbe 130 bzw. eine V-Nut ausgebildet und in dem Adapter 86 ist in einer solchen Konstellation eine zweite, zu der ersten deckungsgleich ausgebildete, periphere V-förmige Kerbe 132 bzw. V-Nut eingelassen (vgl. insb. Figur 1). Die beiden randseitigen Kerben 130, 132 durchsetzen das Anschlusselement 44 und den Adapter 86 jeweils axial vollständig. Im Bereich der beiden Kerben 130, 132 ist naturgemäß eine Positionierung von Magneten 120, 122 unmöglich.

Der Adapter 86 des Parabolspiegels 20 wird zum Ankoppeln an das Anschlusselement 44 der Halteeinheit umfangsseitig so verdreht, dass zur Erzielung der maximalen magnetischen Haltekraft die Magnete 120, 122 im Idealfall vollständig deckungsgleich sind und die beiden V-förmigen Kerben 130, 132 zugleich miteinander fluchten und zusammen mit dem Korn 73 als eine Kimme (vgl. Fig. 1, Bezugsziffer 72) der optionalen oder die Laserzieleinheit nur ergänzenden, visuellen Peil- oder Zieleinrichtung fungieren. Um das Durchschieben des Auslegers 12 mit dem daran angeordneten Ultraschallwandler 16 der Halteeinheit 10 durch die Durchgangsbohrung 84 des Parabolspiegels 20 zum Herstellen der Magnetverbindung 124 zwischen dem Parabolspiegel 20 und der Halteeinheit 10 zu ermöglichen, ist das Korn 73 mittels einer Lagerstelle 134 - wie mit dem schwarzen Doppelpfeil angedeutet - verschwenkbar im Ultraschallwandler 16 aufgenommen bzw. gelagert. Infolgedessen kann das Korn 73 der optischen Peil- oder Zieleinrichtung ausgehend von der lediglich mit einer schwarzen gestrichelten Linie angedeuteten, vollständigen Ausklappstellung in eine mit einer durchgezogenen schwarzen Linie symbolisierte Einklappstellung verbracht werden, in der das Korn zumindest teilweise in dem Ultraschallwandler 16 aufgenommen ist. Hierdurch schließt das Korn 73 in der Einklappstellung zumindest bündig mit einer weitgehend zylindrischen Außenmantelfläche 136 des Ultraschallwandlers 16 ab. Ein Außendurchmesser D₃ des Ultraschallwandlers 16 ist bei eingeklapptem Korn 73 zu diesem Zweck vorzugsweise deutlich kleiner als ein Innendurchmesser D₂ der Durchgangsbohrung 84 des Adapters 86 des Parabolspiegels 20.

### Bezugszeichenliste

- 10: Halteeinheit
- 12: Ausleger
- 14: freies Ende (Ausleger)
- 16: Ultraschallwandler
- 18: elektronischer Verstärker
- 20: Parabolspiegel
- 22: Messobjekt
- 24: Grundkörper (Halteeinheit)
- 26: erster Schenkel
- 28: zweiter Schenkel
- 30: Winkelabschnitt
- 32: Endabschnitt (erster Schenkel)
- 34: Endabschnitt (zweiter Schenkel)
- 36: Handgriff
- 40: Zentrierelement
- 42: Führungselement
- 44: Anschlusselement (Halteeinheit)
- 50: elektronische Auswerteeinheit
- 52: elektrische und/oder optische Leitungen
- 54: optische und/oder akustische Ausgabeeinheit
- 60: Laserzieleinheit
- 62: Messpunkt
- 64: Laserstrahlung
- 66: Reflexionsstrahlung
- 68: Auge
- 70: Laserpunkt
- 71: Peil- oder Zielvorrichtung
- 72: Kimme
- 73: Korn
- 74: Messvorrichtung
- 76: Messempfänger
- 80: parabolischer Grundkörper
- 82: Längsmittelachse
- 84: Durchgangsbohrung (Parabolspiegel)
- 86: Adapter (Parabolspiegel)
- 88: Rückseite (Parabolspiegel)
- 90: Filterzone
- 92: Vorderseite (Parabolspiegel)
- 94: Ultraschallstrahlung
- 96: Brennpunkt
- 98: Umfangskontur
- 100: Magnetverbindung
- 102: Magnet (Adapter)
- 104: Magnet (Anschlusselement)
- 110: Stirnfläche (Adapter)
- 112: Stirnfläche (Anschlusselement)
- 120: Magnet
- 122: Magnet
- 124: Magnetverbindung
- 126: Stirnfläche (Anschlusselement)
- 128: Stirnfläche (Adapter)
- 130: erste V-förmige Kerbe (Anschlusselement)
- 132: V-förmige Kerbe (Adapter)
- 134: Lagerstelle (Korn)
- 136: Außenmantelfläche (Ultraschallwandler)
- D₁: Außendurchmesser (Zentrierelement)
- D₂: Innendurchmesser (Durchgangsbohrung Parabolspiegel)
- D₃: Außendurchmesser (Ultraschallwandler)

## Patentansprüche

1. Messempfänger (76) zur Erfassung von Teilentladungen spannungsführender Bauteile in Hochspannungsanlagen, wobei der Messempfänger (76) einen Parabolspiegel (20) aufweist, der zum Fokussieren von durch elektrische Teilentladungen unter anderem hervorgerufener Ultraschallstrahlung (94) auf einen an einem verjüngten Ausleger (12) einer Halteeinheit (10) angeordneten Ultraschallwandler (16) dient, und wobei die Halteeinheit (10) einen Handgriff (36) für einen Benutzer aufweist, wobei die Halteeinheit (10) zeitweise und zentrisch mit dem Parabolspiegel (20) mechanisch koppelbar ist, **dadurch gekennzeichnet, dass** ein rückseitiger Adapter (86) des Parabolspiegels (20) mit einem Anschlusselement (44) der Halteeinheit durch eine Bajonettverbindung und/oder eine Magnetverbindung (100, 124) koppelbar ist.

2. Messempfänger (76) nach Patentanspruch 1 mit Magnetverbindung, **dadurch gekennzeichnet, dass** die Magnetverbindung (100) mit mindestens einem Magneten (102) des rückseitigen Adapters (86) und/oder mit mindestens einem Magneten (104) des Anschlusselements (44) der Halteeinheit (10) gebildet ist.

3. Messempfänger (76) nach Patentanspruch 2, **dadurch gekennzeichnet, dass** der mindestens eine Magnet (102, 104) der Magnetverbindung (100) im Wesentlichen hohlzylindrisch ausgebildet ist.

4. Messempfänger (76) nach Patentanspruch 1 mit Magnetverbindung, **dadurch gekennzeichnet, dass** die Magnetverbindung (124) mit mehreren von im Wesentlichen umfangsseitig gleichmäßig zueinander beabstandet angeordneten sowie angenähert zylindrischen Magneten (122) des Anschlusselements (44) der Halteeinheit (10) und mit einer gleichen Anzahl von im Wesentlichen umfangsseitig gleichmäßig zueinander beabstandet angeordneten und angenähert zylindrischen Magneten (120) des Adapters (86) des Parabolspiegels (20) gebildet ist, wobei die Magnete (120, 122) des Adapters (86) und des Anschlusselements (44) magnetisch entgegengesetzt gepolt und im mechanisch gekoppelten Zustand von Halteeinheit (10) und Parabolspiegel (20) im Wesentlichen deckungsgleich aneinander liegen.

5. Messempfänger (76) nach einem der Patentansprüche 1 bis 4, **dadurch gekennzeichnet, dass** das Anschlusselement (44) der Halteeinheit (10) mindestens ein Führungselement (42), insbesondere mindestens ein Zentrierelement (40), für den Parabolspiegel (20) aufweist.

6. Messempfänger (76) nach einem der Patentansprüche 1 bis 5, **dadurch gekennzeichnet, dass** die Halteeinheit (10) eine Laserzieleinheit (60) zur Erzeugung einer Laserstrahlung (64) zum Anvisieren eines Messobjekts (22) mittels des Messempfängers (76) aufweist.

7. Messempfänger (76) nach Patentanspruch 6, **dadurch gekennzeichnet, dass** der Parabolspiegel (20) zumindest bereichsweise eine Filterzone (90) aufweist, die für die Laserstrahlung (64) der Laserzieleinheit (60) selektiv durchlässig ist.

8. Messempfänger (76) nach einem der Patentansprüche 1 bis 7, **dadurch gekennzeichnet, dass** der Parabolspiegel (20) zumindest bereichsweise für sichtbares Licht durchlässig ausgebildet ist.

9. Messempfänger (76) nach einem der vorhergehenden Patentansprüche, **dadurch gekennzeichnet, dass** dem Ultraschallwandler (16) mindestens ein elektronischer Verstärker (18) zugeordnet ist.

10. Messvorrichtung (74) zur Erfassung von Teilentladungen spannungsführender Bauteile in Hochspannungsanlagen, umfassend einen Messempfänger (76) einem der Patentansprüche 1 bis 9, wobei zur Schaffung der Messvorrichtung (74) eine elektronische Auswerte- und Ausgabeeinheit (50, 54) mit in die Halteeinheit (10) des Messempfängers (76) integriert ist oder die elektronische Auswerte- und Ausgabeeinheit (50, 54) extern angeordnet und mittels geeigneter elektrischer und/oder optischer Leitungen (52) mit dem mindestens einen Verstärker (18) des Ultraschallwandlers (16) oder direkt mit dem Ultraschallwandler (16) verbunden ist.

## Claims

1. A measuring receiver (76) for detecting partial discharges of live components in high-voltage systems, wherein the measuring receiver (76) has a parabolic mirror (20), which serves for the focussing of ultrasonic radiation (94), caused inter alia by electrical partial discharges, onto an ultrasonic transducer (16) arranged on a tapered arm (12) of a holding unit (10), and wherein the holding unit (10) has a handle (36) for a user, wherein the holding unit (10) is able to be mechanically coupled to the parabolic mirror (20) intermittently and centrically, **characterized in that** a rear-side adapter (86) of the parabolic mirror (20) is able to be coupled to a connection element (44) of the holding unit by a bayonet connection and/or by a magnetic connection (100, 124).

2. The measuring receiver (76) according to Claim 1 with magnetic connection, **characterized in that** the magnetic connection (100) is formed by at least one magnet (102) of the rear-side adapter (86) and/or by at least one magnet (104) of the connection element (44) of the holding unit (10).

3. The measuring receiver (76) according to Claim 2, **characterized in that** the at least one magnet (102, 104) of the magnetic connection (100) is formed substantially in a hollow-cylindrical manner.

4. The measuring receiver (76) according to Claim 1 with magnetic connection, **characterized in that** the magnetic connection (124) is formed with several of magnets (122) of the connection element (44) of the holding unit (10), arranged substantially circumferentially uniformly spaced apart from one another, and approximately cylindrical, and with an identical number of magnets (120) of the adapter (86) of the parabolic mirror (20), arranged substantially circumferentially uniformly spaced apart from one another and approximately cylindrical, wherein the magnets (120, 122) of the adapter (86) and of the connection element (44) have opposed magnetic polarity and in the mechanically coupled state of holding unit (10) and parabolic mirror (20) abut one another substantially congruently.

5. The measuring receiver (76) according to one of Claims 1 to 4, **characterized in that** the connection element (44) of the holding unit (10) has at least one guide element (42), in particular at least one centring element (40), for the parabolic mirror (20).

6. The measuring receiver (76) according to one of Claims 1 to 5, **characterized in that** the holding unit (10) has a laser target unit (60) for generating a laser radiation (64) for targeting a measurement object (22) by means of the measuring receiver (76).

7. The measuring receiver (76) according to Claim 6, **characterized in that** the parabolic mirror (20) has at least partially a filter zone (90), which is selectively permeable to the laser radiation (64) of the laser target unit (60).

8. The measuring receiver (76) according to one of Claims 1 to 7, **characterized in that** the parabolic mirror (20) is formed at least partially to be permeable for visible light.

9. The measuring receiver (76) according to one of the preceding claims, **characterized in that** at least one electronic amplifier (18) is associated with the ultrasonic transducer (16).

10. A measuring device (74) for detecting partial discharges of live components in high-voltage systems, comprising a measuring receiver (76) according to one of Claims 1 to 9, wherein for creating the measuring device (74), an electronic evaluation- and output unit (50, 54) is integrated into the holding unit (10) of the measuring receiver (76), or the electronic evaluation- and output unit (50, 54) is arranged externally and is connected to the at least one amplifier (18) of the ultrasonic transducer (16) by means of suitable electrical and/or optical lines (52), or is connected directly to the ultrasonic transducer (16).

## Revendications

1. Récepteur de mesure (76) pour détecter des décharges partielles dans des composants sous tension dans des systèmes à haute tension, dans lequel le récepteur de mesure (76) présente un miroir parabolique (20), qui est utilisé pour focaliser le rayonnement ultrasonique (94) provoqué par des décharges partielles électriques, entre autres un transducteur à ultrasons (16) agencé sur un bras conique (12) d'une unité de maintien (10), et dans lequel l'unité de maintien (10) présente une poignée (36) pour un utilisateur, dans lequel l'unité de maintien (10) peut être mécaniquement couplée ponctuellement et centrée au miroir parabolique (20), **caractérisé en ce que** l'adaptateur arrière (86) du miroir parabolique (20) peut être couplé à un élément de connexion (44) de l'unité de maintien par une connexion à baïonnette et/ou une connexion magnétique (100, 124).

2. Récepteur de mesure (76) selon la revendication 1 comportant une connexion magnétique, **caractérisé en ce que** la connexion magnétique (100) est reliée à au moins un aimant (102) de l'adaptateur arrière (86) et/ou est formée avec au moins un aimant (104) de l'élément de connexion (44) de l'unité de maintien (10) .

3. Récepteur de mesure (76) selon la revendication 2, **caractérisé en ce que** au moins un aimant (102, 104) de la connexion magnétique (100) est essentiellement de forme cylindrique creuse.

4. Récepteur de mesure (76) selon la revendication 1 comportant une connexion magnétique, **caractérisé en ce que** la connexion magnétique (124) est formée avec une pluralité d'aimants approximativement cylindriques (122) de l'élément de connexion (44) de l'unité de maintien (10) qui sont disposés essentiellement circonférentiellement à égales distances les uns des autres et avec un nombre égal d'aimants (120) sensiblement équidistants circonférentiellement et approximativement cylindriques de l'adaptateur (86) du miroir parabolique (20), dans lequel les aimants (120, 122) de l'adaptateur (86) et de l'élément de connexion (44) avec une polarité magnétique opposée et dans l'état couplé mécaniquement de l'unité de maintien (10) et du miroir parabolique (20) sont essentiellement congrus l'un à l'autre.

5. Récepteur de mesure (76) selon une des revendications 1 à 4, **caractérisé en ce que** l'élément de connexion (44) de l'unité de maintien (10) présente au moins un élément de guidage (42), notamment au moins un élément de centrage (40), pour le miroir parabolique (20).

6. Récepteur de mesure (76) selon une des revendications 1 à 5, **caractérisé en ce que** l'unité de maintien (10) présente une unité de visée laser (60) pour générer un rayonnement laser (64) pour viser un objet de mesure (22) au moyen du récepteur de mesure (76).

7. Récepteur de mesure (76) selon la revendication 6, **caractérisé en ce que** le miroir parabolique (20) présente au moins dans certaines zones une zone de filtre (90) sélectivement perméable au rayonnement laser (64) de l'unité de visée laser (60).

8. Récepteur de mesure (76) selon une des revendications 1 à 7, **caractérisé en ce que** le miroir parabolique (20) est conçu de manière à être transparent à la lumière visible au moins par endroits.

9. Récepteur de mesure (76) selon une des revendications précédentes, **caractérisé en ce que** le transducteur à ultrasons (16) est associée à au moins un amplificateur électronique (18).

10. Dispositif de mesure (74) pour détecter des décharges partielles de composants sous tension dans des systèmes à haute tension, comprenant un récepteur de mesure (76) selon une des revendications 1 à 9, une unité électronique d'évaluation et de sortie (50, 54), dans lequel pour créer le dispositif de mesure (74) une unité électronique d'évaluation et de sortie (50, 54) est intégrée dans l'unité de maintien (10) du récepteur de mesure (76) ou l'unité électronique d'évaluation et de sortie (50,54) est agencée extérieurement et au moyen de lignes électriques et/ou optiques appropriées (52) avec au moins un amplificateur (18) du transducteur à ultrasons (16) ou est directement connectée au transducteur à ultrasons (16) .
